# FASCICULE DE BREVET EUROPEEN

(11) **EP 3 549 164 B1**
(45) Date de publication et mention de la délivrance du brevet: **29.09.2021**
(21) Numéro de dépôt: 17808375.4
(22) Date de dépôt: 16.11.2017
(51) Int. Cl.: H01L 23/36, H01L 23/373, H01L 23/433

(54) **DISPOSITIF D'EVACUATION DE CHALEUR**
VORRICHTUNG ZUR BESEITIGUNG VON WÄRME
DEVICE FOR REMOVING HEAT

(30) Priorité: 30.11.2016 FR 1661677
(43) Date de publication de la demande: 09.10.2019
(73) Titulaire: Sagemcom Broadband SAS, 92500 Rueil-Malmaison (FR)
(72) Inventeur: BOURGOIN, Gilles, 92500 Rueil Malamaison (FR); TISNE, Alain, 92500 Rueil Malamaison (FR)
(74) Mandataire: Lavaud, Thomas
(86) Numéro de dépôt international: PCT/EP2017/079460
(87) Numéro de publication internationale: WO 2018/099729

(56) Documents cités:
- WO-A1-02/099880
- WO-A1-2015/111242
- JP-A- 2005 019 792
- JP-A- 2005 109 005
- JP-A- 2006 210 940
- JP-A- 2010 258 179
- JP-A- 2016 096 249
- US-A- 5 805 417

## Description

L'invention concerne le domaine des dispositifs d'évacuation de chaleur générée par un composant électronique.

### ARRIERE PLAN DE L'INVENTION

L'efficacité de la dissipation thermique est un enjeu crucial dans la conception de nombreux équipements électroniques, notamment lorsque ces équipements électroniques comportent des composants électroniques à forte densité énergétique, et que ces équipements électroniques doivent répondre à des exigences de réduction de masse et d'encombrement.

La puissance dissipée par unité de surface à l'intérieur d'un tel équipement électronique peut en effet être très importante et générer une augmentation de température susceptible de conduire à la défaillance des composants électroniques de l'équipement électronique.

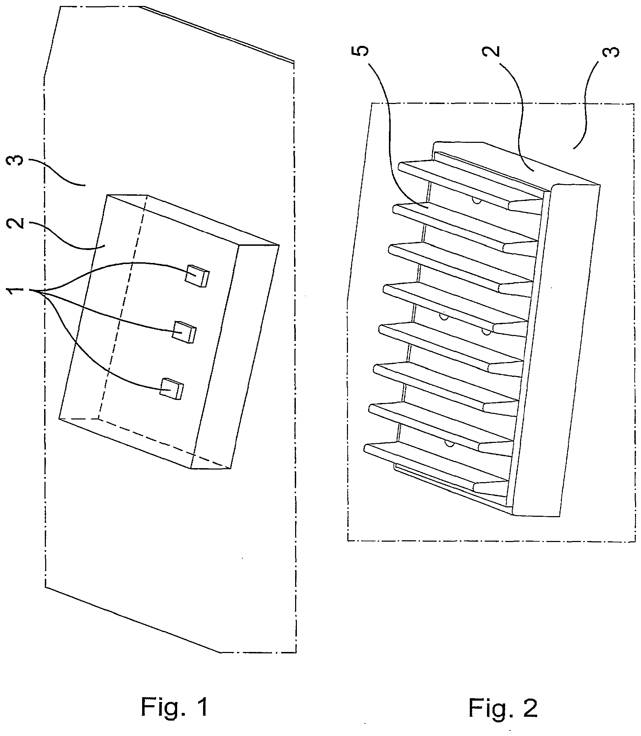

En référence à la figure 1, ce problème est particulièrement délicat à résoudre dans le cas de composants électroniques à forte densité énergétique tel que des amplificateurs de puissance radiofréquence 1, qui sont positionnés à l'intérieur d'un capot de blindage 2 destiné à isoler électromagnétiquement les amplificateurs de puissance radiofréquence 1.

Pour évacuer la chaleur produite par les amplificateurs 1, il est connu de positionner un pad thermique sur les amplificateurs 1. Cependant, un tel pad thermique n'est pas transparent électromagnétiquement à cause de sa constante diélectrique relative εr qui est supérieure à 1. Par ailleurs, la taille relativement importante du pad thermique, qui recouvre une surface bien supérieure à celle des amplificateurs 1 afin de compenser les dérives de positionnement du pad thermique, risque de provoquer un couplage entre une entrée et une sortie du circuit constitué par les amplificateurs 1 et de réduire l'efficacité dudit circuit.

Il est aussi connu de refroidir les amplificateurs 1 en utilisant uniquement le pouvoir dissipatif de la carte électronique 3 sur laquelle sont montés les amplificateurs 1. Les calories sont alors évacuées par la base de chaque amplificateur 1 vers la carte électronique 3. Cependant, les calories évacuées provenant d'un amplificateur 1 contribuent alors à échauffer les autres amplificateurs 1.

Il est aussi connu, en référence à la figure 2, de monter un dissipateur à ailettes 5 sur la paroi supérieure du capot de blindage 2.

Enfin, il est connu d'utiliser un ventilateur pour refroidir le capot de blindage 2 et les amplificateurs 1 présents à l'intérieur du capot de blindage 2.

Les documents JP2005019792 et US5,805,417 divulguent autres structures de dissipation thermique comprenant un drain thermique rigide.

### OBJET DE L'INVENTION

L'invention a pour objet d'améliorer l'évacuation de la chaleur produite par un composant électronique.

### RESUME DE L'INVENTION

En vue de la réalisation de ce but, on propose un dispositif d'évacuation destiné à évacuer une chaleur produite tel que décrit dans la revendication 1.

Le drain permet d'évacuer efficacement vers le dissipateur thermique la chaleur produite par le composant électronique en effectuant une extraction de chaleur localisée. L'évacuation de chaleur est efficace quelle que soit l'épaisseur du composant électronique et est donc, en particulier, robuste aux variations d'épaisseur dues aux tolérances de fabrication du composant électronique. L'évacuation est efficace quelle que soit la distance entre le composant électronique et le dissipateur thermique.

On obtient ainsi une solution simple, peu coûteuse et très efficace pour dissiper la chaleur produite par le composant électronique. On note que, dans la situation représentée sur les figures 1 à 2, et dans le cas où le dispositif d'évacuation est destiné à évacuer une chaleur produite par une pluralité de composants électroniques, le dispositif d'évacuation ne génère aucun couplage électromagnétique ou perturbation électromagnétique entre les composants électroniques.

L'invention concerne aussi un équipement électronique comportant une carte électronique, un composant électronique et un dispositif d'évacuation tel que celui qui vient d'être décrit.

L'invention sera mieux comprise à la lumière de la description qui suit de modes de mise en œuvre particuliers non limitatifs de l'invention.

### BREVE DESCRIPTION DES DESSINS

Il sera fait référence aux dessins annexés, parmi lesquels :
- la figure 1 représente une carte électronique, des composants électroniques et un capot de blindage ;
- la figure 2 représente une carte électronique, un capot de blindage et un dissipateur thermique monté sur le capot de blindage ;
- la figure 3 représente une vue de dessus et une vue de dessous, en perspective, d'un châssis et de drains thermiques d'un dispositif d'évacuation selon un premier mode de réalisation de l'invention ;
- la figure 4 représente une vue en coupe et en perspective du châssis et des drains, le châssis étant monté sur une carte électronique ;
- la figure 5 est une vue analogue à la figure 4, représentant en outre un capot de blindage et une couche élastiquement déformable et thermiquement conductrice ;
- la figure 6 est une vue analogue à la figure 5, représentant en outre un dissipateur thermique sur le capot de blindage ;
- la figure 7 représente une répartition de température sur la carte électronique dans la situation de la figure 2 ;
- la figure 8 représente une répartition de température sur la carte électronique dans la situation de la figure 6 ;
- la figure 9 est une figure analogue à la figure 3, pour un dispositif d'évacuation selon un deuxième mode de réalisation de l'invention ;
- la figure 10 est une figure analogue à la figure 6, pour le dispositif d'évacuation selon le deuxième mode de réalisation de l'invention.

### DESCRIPTION DETAILLEE DE L'INVENTION

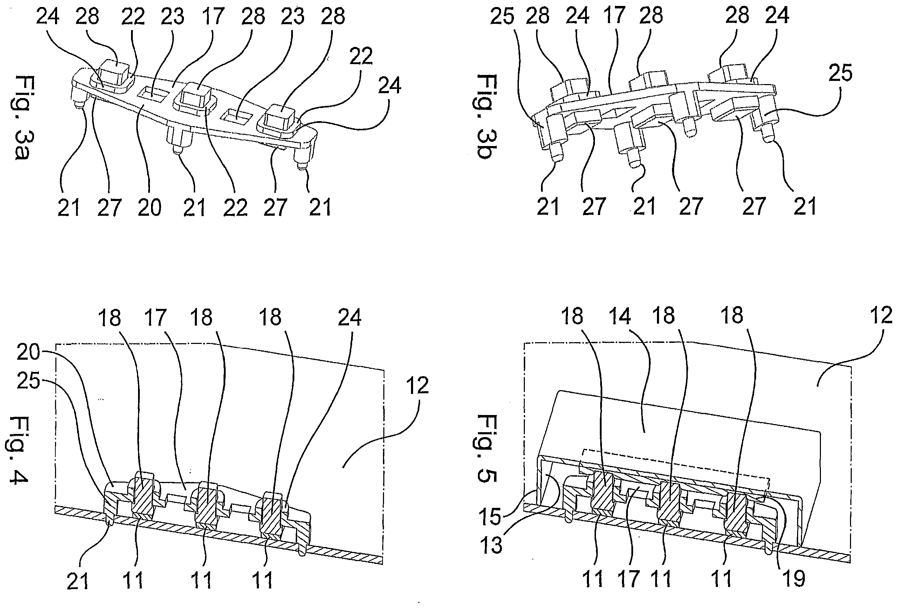

En référence aux figures 3 à 6, le dispositif d'évacuation selon un premier mode de réalisation de l'invention 10 est ici destiné à évacuer la chaleur produite par trois amplificateurs de puissance radiofréquence 11 montés alignés sur une carte électronique 12 d'un équipement électronique, et recouverts par un capot de blindage 13. Le capot de blindage 13 isole électromagnétiquement les trois amplificateurs 11, c'est-à-dire qu'il empêche, d'une part, que le fonctionnement des trois amplificateurs 11 soit dégradé par des perturbations électromagnétiques externes, et d'autre part, que le fonctionnement des trois amplificateurs 11 produise des perturbations électromagnétiques susceptibles de dégrader le fonctionnement d'autres composants électroniques.

Le capot de blindage 13 comporte une paroi supérieure formant une platine 14, et des parois latérales 15. Le capot de blindage 13 (et donc la platine 14) est fixé à la carte électronique 12 par des moyens de fixation classiques et non décrits ici.

Le dispositif d'évacuation 10 comporte un dissipateur thermique 16, un châssis 17, trois drains thermiques rigides 18 et une couche élastiquement déformable et thermiquement conductrice 19.

Le dissipateur thermique 16 est ici un dissipateur thermique à ailettes, qui est monté sur la platine 14 (plus précisément, sur une face supérieure de la platine 14). Le dissipateur thermique 16 s'étend ainsi au-dessus et à distance des amplificateurs 11.

Le châssis 17 s'étend entre les amplificateurs 11 et la platine 14.

Le châssis 17 comporte une plateforme 20, des pieds 25 qui surélèvent la plateforme 20, et des moyens de fixation 21 du châssis 17 à la carte électronique 12. Les moyens de fixation 21 peuvent être des moyens de fixation par bouterollage, par encliquetage, par collage, ou tout autre type de fixation.

La plateforme 20 s'étend ici parallèlement à la carte électronique 12 et à la platine 14. Cinq cavités alignées sont pratiquées dans la plateforme 20, parmi lesquelles trois cavités de coulissement 22 et deux cavités simples 23. Chaque cavité simple 23 est située entre deux cavités de coulissement 22.

Chaque cavité 22, 23 débouche au niveau d'une ouverture supérieure sur une face supérieure de la plateforme 20, et au niveau d'une ouverture inférieure sur une face inférieure de la plateforme 20. L'ouverture supérieure de chaque cavité de coulissement 22 est entourée par une surépaisseur de la plateforme 20 formant une collerette 24.

Chaque drain 18 présente la forme d'un piston et comporte une première extrémité et une deuxième extrémité. La première extrémité est une tête 27 du piston, et la deuxième extrémité est une extrémité 28 d'une tige du piston.

Chaque drain 18 est monté sur la plateforme 20 du châssis 17 pour coulisser perpendiculairement à la carte électronique 12 au travers d'une cavité de coulissement 22 et de la collerette 24 associée. La tête 27 du piston du drain 18 s'étend du côté d'une face inférieure de la plateforme 20. Les cavités de coulissement 22 et les drains 18 sont positionnés de sorte que, lorsque le dispositif d'évacuation 10 est monté sur la carte électronique 12 au-dessus des amplificateurs 11, la tête 27 de chaque drain 18 est positionnée en regard de l'un des amplificateurs 11.

La couche élastiquement déformable 19, quant à elle, est fixée à la platine 14 (plus précisément, sur une face inférieure de la platine 14), et s'étend au-dessus de la plateforme 20 du châssis 17 et des trois drains 18.

Lorsque le dispositif d'évacuation 10 est monté sur la carte électronique 12 au-dessus des amplificateurs 11, chaque drain 18 peut être déplacé pour coulisser de manière à ce que la tête 27 du drain 18 vienne en contact avec l'amplificateur 11 en regard duquel il est positionné. La couche élastiquement déformable 19 rappelle élastiquement le drain 18 en appui contre l'amplificateur 11 quelle que soit l'épaisseur de l'amplificateur 11.

Ainsi, quelle que soit l'épaisseur de l'amplificateur 11 et donc, en particulier, quelles que soient les variations d'épaisseur de l'amplificateur 11 dues aux tolérances de fabrication de l'amplificateur 11, le drain 18 est en contact avec l'amplificateur 11 d'une part et avec la couche élastiquement déformable 19 d'autre part, ladite couche élastiquement déformable 19 étant elle-même en contact avec la platine 14 sur laquelle est montée le dissipateur thermique 16. La chaleur produite par l'amplificateur 11 peut donc être évacuée par conduction jusqu'au dissipateur thermique 16 puis dissipée par ledit dissipateur thermique 16.

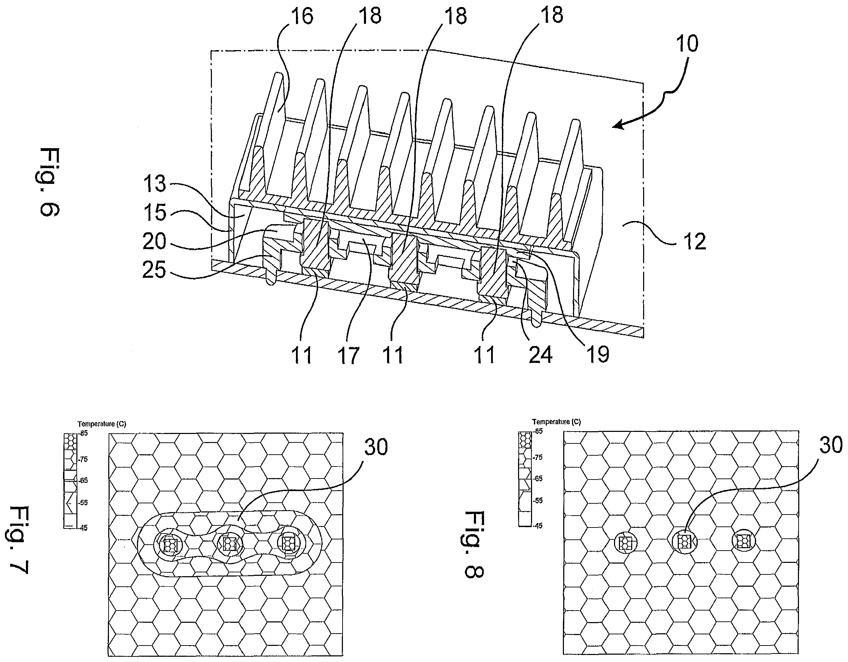

L'efficacité du dispositif d'évacuation selon le premier mode de réalisation de l'invention 10 est illustrée par les figures 7 et 8.

La répartition de température de la figure 7, obtenue par simulation, correspond à la carte électronique 12 sur laquelle sont montés les trois amplificateurs 11 recouverts par le capot de blindage 13, sans que le dispositif d'évacuation 10 ne soit utilisé. Chaque amplificateur 11 a une forme de parallélépipède carré de côté 3mm et d'épaisseur 0,5mm. La carte électronique 12 possède aussi la forme d'un parallélépipède carré de côté 60mm. Le capot de blindage 13 présente la forme d'un parallélépipède rectangle de longueur 60mm, de largeur 20mm et d'épaisseur 5mm. Le dissipateur thermique 16 comporte dix ailettes de 5mm de hauteur et 3mm d'épaisseur à la base.

On note que la température moyenne de chaque amplificateur 11 est de 120°C environ. On note aussi que la zone 30 située autour des amplificateurs 11 présente une température de 65°C environ.

La répartition de température de la figure 8 correspond à une situation similaire à celle de la figure 7, dans laquelle le dispositif d'évacuation selon le premier mode de réalisation 10 est utilisé.

Chaque drain 18 est fabriqué ici en polyamide thermique présentant une conductivité verticale égale à 8W/m.K et une conductivité horizontale égale à 1W/m.K. La couche élastiquement déformable 19 présente une épaisseur de 0,5mm et une conductivité de 2W/m.K.

On note que la température moyenne de chaque amplificateur 11 est de 80°C environ, soit une baisse de 40°C. On note aussi que la zone 30 présente une température de 55°C environ, soit une baisse de 10°C environ.

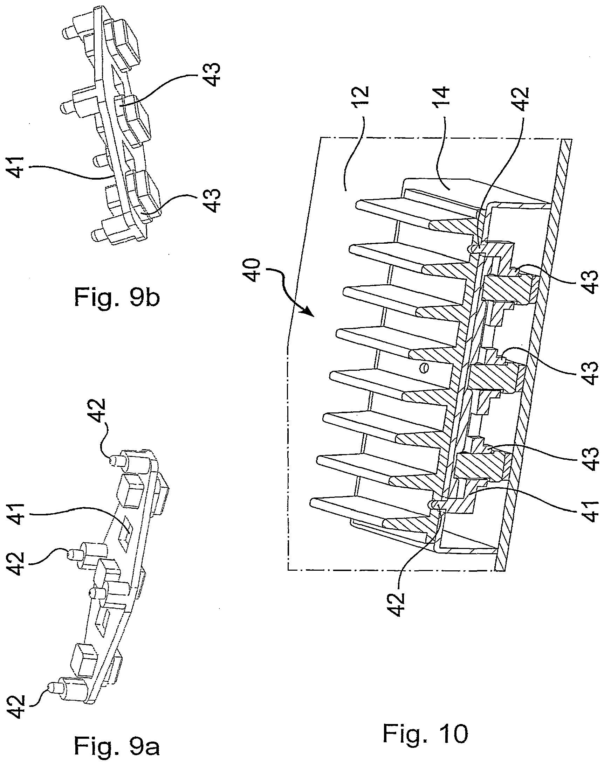

En référence aux figures 9 et 10, le dispositif d'évacuation selon un deuxième mode de réalisation de l'invention 40 est semblable au dispositif d'évacuation selon le premier mode de réalisation de l'invention 10, si ce n'est que cette fois, le châssis 41 est fixé à la platine 14 (plus précisément, à une face inférieure de la platine 14) et non à la carte électronique 12. Les moyens de fixation 42 du châssis 41 sont donc des moyens de fixation du châssis 41 à la platine 14. On note de plus que, cette fois, ce sont les ouvertures inférieures des cavités de coulissement qui sont chacune entourées par une surépaisseur de la plateforme formant une collerette 43.

Bien entendu, l'invention n'est pas limitée aux modes de réalisation décrits mais englobe toute variante entrant dans le champ de l'invention telle que définie par les revendications.

Bien que l'on ait indiqué que les dispositifs d'évacuation ici décrits évacuent la chaleur produite par des amplificateurs de puissance radiofréquence, l'invention s'applique bien sûr à tout type de composant électronique.

Bien que l'on ait décrit des dispositifs d'évacuation utilisés pour évacuer la chaleur produite par trois composants électroniques, un dispositif d'évacuation selon l'invention peut parfaitement être conçu pour évacuer la chaleur produite par un nombre différent de composants électroniques (au moins un).

La platine, qui est ici une paroi supérieure d'un capot de blindage, pourrait parfaitement être une platine simple uniquement destinée à porter le dissipateur thermique.

Dans tout le document, le terme « composant électronique » fait référence à tous type de composant susceptible d'être monté sur une carte électronique. Un tel composant est par exemple un composant électronique à base de semi-conducteur tel qu'un amplificateur, un processeur, une diode, un transistor, etc. Un tel composants peut aussi être un composant actif ou bien un composant passif ou électrique, tel qu'une résistance, un bobinage, un condensateur, un filtre, etc.

## Revendications

1. Dispositif d'évacuation destiné à évacuer une chaleur produite par au moins un composant électronique (11) monté sur une carte électronique (12), le dispositif d'évacuation comportant :
- un dissipateur thermique (16) monté sur une platine (14) pourvue de moyens de sa fixation à la carte électronique pour que le dissipateur s'étende au-dessus et à distance du composant électronique ;
- un châssis (17 ; 41) s'étendant entre le composant électronique et la platine, et des moyens de fixation du châssis à la platine ou à la carte électronique ;
- un drain thermique rigide (18) qui est monté coulissant sur le châssis sans être fixé au châssis lorsque le châssis est fixé à la platine ou à la carte électronique par les moyens de fixation, le drain thermique rigide (18) étant monté sur le châssis pour coulisser perpendiculairement à la carte électronique (12) et qui a une première extrémité de contact avec le composant et une deuxième extrémité en appui sur une couche élastiquement déformable et thermiquement conductrice (19) fixée à la platine pour rappeler élastiquement le drain thermique rigide (18) en appui contre le composant électronique (11) quelle que soit l'épaisseur du composant électronique, la couche élastiquement déformable et thermiquement conductrice étant positionnée entre le dissipateur thermique et le châssis.

2. Dispositif d'évacuation selon la revendication 1, dans lequel le drain thermique rigide (18) présente la forme d'un piston comprenant une tige et une tête, la première extrémité du drain thermique rigide étant une tête (27) du piston et la deuxième extrémité étant une extrémité (28) de la tige.

3. Dispositif d'évacuation selon la revendication 1, dans lequel le drain thermique rigide (18) est fabriqué en polyamide.

4. Dispositif d'évacuation selon la revendication 1, dans lequel la platine (14) est une paroi supérieure d'un capot de blindage (13).

5. Dispositif d'évacuation selon la revendication 1, dans lequel le dissipateur thermique (16) est un dissipateur thermique à ailettes.

6. Equipement électronique comportant une carte électronique (12), un composant électronique (11) et un dispositif d'évacuation (10 ; 40) selon l'une des revendications précédentes.

7. Equipement électronique selon la revendication 6, dans lequel le composant électronique est un amplificateur de puissance radiofréquence (11).

## Patentansprüche

1. Ableitungsvorrichtung, die dazu bestimmt ist, Wärme abzuleiten, die von mindestens einem elektronischen Bauteil (11) erzeugt wird, das auf einer Leiterplatte (12) montiert ist, wobei die Ableitungsvorrichtung umfasst:
- einen Wärmeableiter (16), der auf einer Platte (14) montiert ist, die mit Mitteln für ihre Befestigung auf der Leiterplatte versehen ist, sodass sich der Ableiter über und mit Abstand zur Leiterplatte erstreckt;
- einen Rahmen (17; 41), der sich zwischen dem elektronischen Bauteil und der Platte erstreckt, und Befestigungsmittel zum Befestigen des Rahmens an der Platte oder an der Leiterplatte;
- eine starre Wärmeabführung (18), die verschiebbar an dem Rahmen gelagert ist, ohne am Rahmen befestigt zu sein, wenn der Rahmen an der Platte oder an der Leiterplatte durch die Befestigungsmittel befestigt ist, wobei die starre Wärmeabführung (18) an dem Rahmen senkrecht zur Leiterplatte (12) verschiebbar gelagert ist und ein erstes Ende in Kontakt mit dem Bauteil und ein zweites Ende in Anlage auf einer elastisch verformbaren und wärmeleitenden Schicht (19) hat, die an der Platte befestigt ist, um die starre Wärmeabführung (18) elastisch in Anlage an das elektronische Bauteil (11) ungeachtet der Dicke des elektronischen Bauteils rückzustellen, wobei die elastisch verformbare und wärmeleitende Schicht zwischen dem Wärmeableiter und dem Rahmen positioniert ist.

2. Ableitungsvorrichtung nach Anspruch 1, bei der die starre Wärmeabführung (18) die Form eines Kolbens aufweist, der eine Stange und einen Kopf umfasst, wobei das erste Ende der starren Wärmeabführung ein Kopf (27) des Kolbens und das zweite Ende ein Ende (28) der Stange ist.

3. Ableitungsvorrichtung nach Anspruch 1, bei der die starre Wärmeabführung (18) aus Polyamid gefertigt ist.

4. Ableitungsvorrichtung nach Anspruch 1, bei der die Platte (14) eine obere Wand einer Abschirmabdeckung (13) ist.

5. Ableitungsvorrichtung nach Anspruch 1, bei der der Wärmeableiter (16) ein Wärmeableiter mit Rippen ist.

6. Elektronische Ausrüstung, umfassend eine Leiterplatte (12), ein elektronisches Bauteil (11) und eine Ableitungsvorrichtung (10; 40) nach einem der vorhergehenden Ansprüche.

7. Elektronische Ausrüstung nach Anspruch 6, bei der das elektronische Bauteil ein Hochfrequenz-Leistungsverstärker (11) ist.

## Claims

1. A heat sink device for removing heat produced by at least one electronic component (11) mounted on an electronic card (12), the heat sink device comprising:
- a heat dissipater (16) mounted on a plate (14) provided with means for fastening it on the electronic card so that the heat dissipater extends over and at a distance from the electronic component;
- a bridge (17; 41) extending between the electronic component and the plate, and fastener means for fastening the bridge to the plate or to the electronic card;
- a rigid thermal drain (18) that is unfixedly and slidably mounted on the bridge while the bridge is fastened to the plate or to the electronic card by the fastener means, the rigid thermal drain (18) being mounted on the bridge to slide perpendicularly to the electronic card (12) and that has a first end in contact with the electronic component and a second end pressing against an elastically deformable and thermally conductive layer (19) fastened to the plate in order to urge the rigid thermal drain (18) elastically to bear against the electronic component (11) regardless of the thickness of the electronic component, the elastically deformable and thermally conductive layer being positioned between the heat dissipater and the bridge.

2. A heat sink device according to claim 1, wherein the rigid thermal drain (18) is in the form of a piston having a rod and a head, the first end of the rigid thermal drain being a head (27) of the piston and the second end being an end (28) of the rod.

3. A heat sink device according to claim 1, wherein the rigid thermal drain (18) is made of polyamide.

4. A heat sink device according to claim 1, wherein the plate (14) is a top wall of a shielding cover (13).

5. A heat sink device according to claim 1, wherein the heat dissipater (16) is a finned heat dissipater.

6. Electronic equipment including an electronic card (12), an electronic component (11), and a heat sink device (10; 40) according to any preceding claim.

7. Electronic equipment according to claim 6, wherein the electronic component is a radiofrequency power amplifier (11).
